# EUROPEAN PATENT APPLICATION

(11) **EP 3 200 242 A1**
(43) Date of publication of application: **02.08.2017**
(21) Application number: 15844564.3
(22) Date of filing: 17.09.2015
(51) Int. Cl.: H01L 31/068, H01L 29/41

(54) **SOLAR CELL ELEMENT**

(30) Priority: 22.09.2014 JP 2014192412
(71) Applicant: KYOCERA Corporation, Kyoto 612-8501 (JP)
(72) Inventor: MATSUSHIMA, Norihiko, Kyoto-shi Kyoto 612-8501 (JP); TESHIMA, Ryota, Kyoto-shi Kyoto 612-8501 (JP); ITO, Takeshi, Kyoto-shi Kyoto 612-8501 (JP)
(74) Representative: Viering, Jentschura & Partner mbB Patent- und Rechtsanwälte
(86) International application number: PCT/JP2015/076546
(87) International publication number: WO 2016/047564

(57) **Abstract**

A solar cell element of the present invention comprises a silicon substrate 1 having a plurality of recessed portions 11 in one main surface; a passivation layer 9 that is disposed on the one main surface of the silicon substrate 1 and has holes 91 in positions corresponding to the recessed portions 11; a first conductive portion 13 disposed in each of the holes 91 in the passivation layer 9; an electrode that is disposed on the passivation layer 9, is connected to the first conductive portion 13, and contains aluminum; a second conductive portion 14 that is connected to each of the silicon substrate 1 and the first conductive portion 13 while being disposed in each of the recessed portions 11 of the silicon substrate 1, and contains aluminum and silicon; and a void that is located in each of the recessed portions 11 of the silicon substrate 1 and does not include the second conductive portion 14 disposed therein.

## Description

### TECHNICAL FIELD

The present invention relates to a solar cell element.

### BACKGROUND ART

A passivated emitter and rear cell (PERC) structure has been known as one of structures of a solar cell element (see Japanese Patent Application Laid-Open No. 2005-150609, for example). The solar cell element includes a passivation layer disposed on a silicon substrate. The passivation layer has holes through which a material made of aluminum for an electrode enters. Thus, a conductive paste disposed on the passivation layer is fired to form the electrode not only on the passivation layer but also in the holes.

When the conductive paste is fired to form the electrode, a diffusion rate of silicon into aluminum at firing temperature is higher than a diffusion rate of aluminum into silicon. For this reason, voids are likely to be formed in a contact surface between the silicon substrate and the electrode.

Thus, a solar cell element in which the voids are filled with an aluminum-silicon alloy by using the conductive paste to which aluminum-silicon alloy powder and silicon powder are added has been proposed (see Japanese Patent Application Laid-Open No. 2013-143499, for example).

### SUMMARY OF INVENTION

### PROBLEMS TO BE SOLVED BY THE INVENTION

However, when the voids are filled with the aluminum-silicon alloy, stress concentration is likely to occur at a boundary portion between the aluminum-silicon alloy and the silicon substrate due to a difference in coefficient of thermal expansion between the aluminum-silicon alloy and the silicon substrate. This may result in a crack in the silicon substrate and a decrease in output of the solar cell element.

One object of the present invention is to provide a solar cell element having excellent reliability while maintaining efficiency of photoelectric conversion.

### MEANS TO SOLVE THE PROBLEMS

To solve the problems above, a solar cell element according to one aspect of the present invention comprises: a silicon substrate having a plurality of recessed portions in one main surface; a passivation layer that is disposed on the one main surface of the silicon substrate and has holes in positions corresponding to the recessed portions; a first conductive portion disposed in each of the holes in the passivation layer; an electrode that is disposed on the passivation layer, is connected to the first conductive portion, and contains aluminum; a second conductive portion that is connected to each of the silicon substrate and the first conductive portion while being disposed in each of the recessed portions of the silicon substrate, and contains aluminum and silicon; and a void that is located in each of the recessed portions of the silicon substrate and does not include the second conductive portion disposed therein.

### EFFECTS OF THE INVENTION

The solar cell element having the above-mentioned configuration has the excellent reliability while maintaining the efficiency of photoelectric conversion.

### BRIEF DESCRIPTION OF THE DRAWINGS

Fig. 1 illustrates a plan view showing an external appearance of a first main surface side of a solar cell element according to one embodiment of the present invention.
Fig. 2 illustrates a plan view showing an external appearance of a second main surface side of the solar cell element according to one embodiment of the present invention.
Fig. 3 illustrates a cross-sectional view taken along an alternate long and short dashed line III-III of Figs. 1 and 2.
Fig. 4 illustrates an enlarged cross-sectional view showing an enlarged portion corresponding to an IV portion of Fig. 3.
Fig. 5 illustrates an enlarged cross-sectional view showing an aspect different from Fig. 4.
Fig. 6 illustrates an enlarged cross-sectional view showing an aspect different from Fig. 4.
Fig. 7 illustrates an enlarged cross-sectional view showing an aspect different from Fig. 4.
Figs. 8(a) to 8(e) each illustrate a partial cross-sectional view showing a method for manufacturing a solar cell element according to one embodiment of the present invention.

### DETAILED DESCRIPTION

An embodiment of a solar cell element according to the present invention will be described below in detail with reference to the drawings. The drawings are schematically illustrated.

### <Configuration of Solar Cell Element>

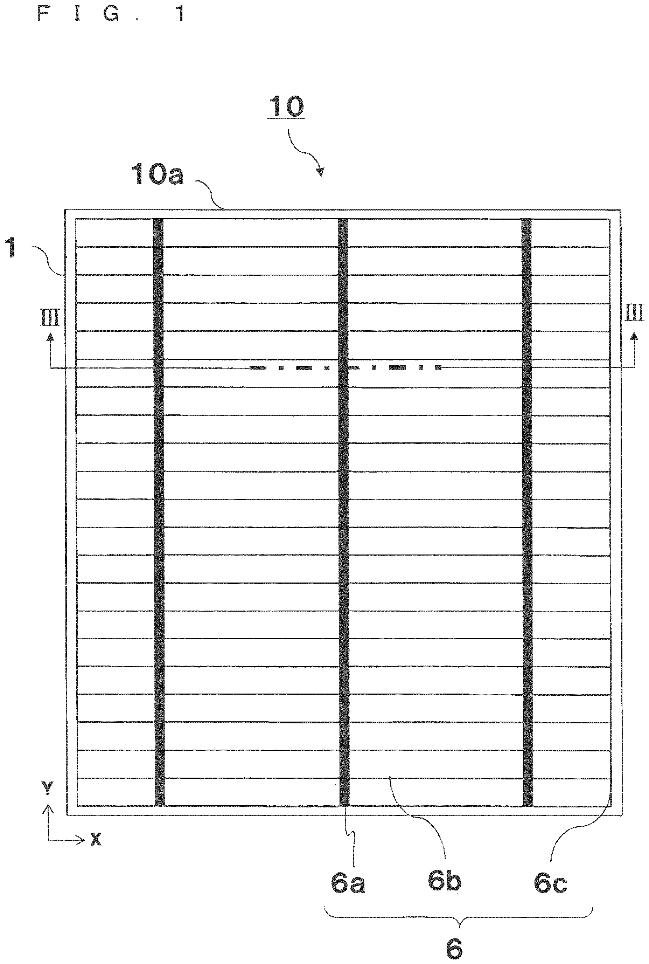

Figs. 1 to 3 illustrate a solar cell element 10 in the present embodiment. The solar cell element 10 has a first main surface 10a that is a light receiving surface (front surface) mainly for receiving incident light and a second main surface 10b that is a main surface (back surface) located opposite to the first main surface 10a.

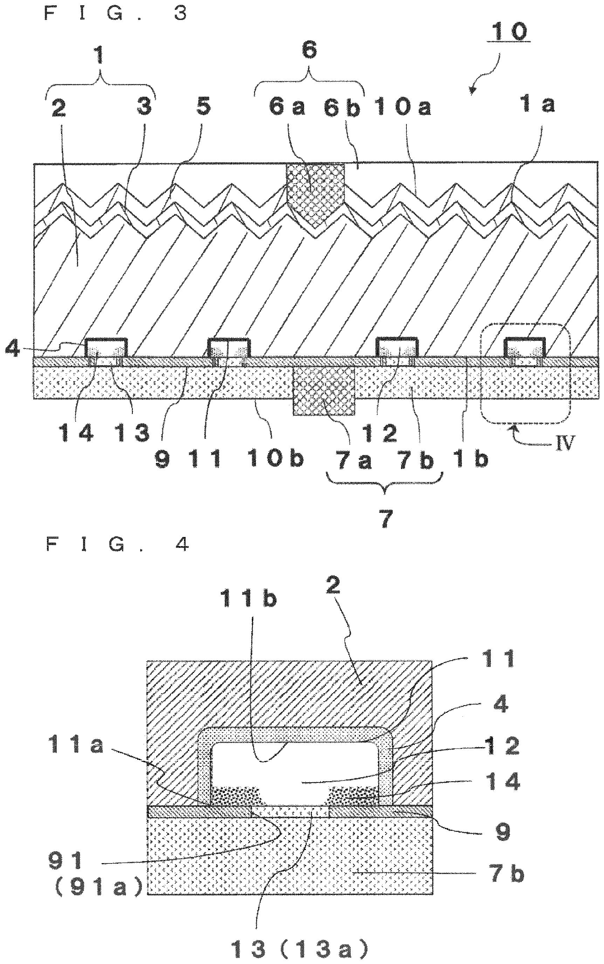

As illustrated in Fig. 3, a silicon substrate 1 has a first main surface 1a and a second main surface 1b located opposite to the first main surface. The silicon substrate 1 includes a first semiconductor layer 2 that is a semiconductor region of one conductivity type (such as a p-type) and a second semiconductor layer 3 that is a semiconductor region of a reverse conductivity type (such as an n-type) located on the first main surface 1a side of the first semiconductor layer 2. The silicon substrate 1 has a plurality of recessed portions 11 in the second main surface 1b, and a third semiconductor layer 4 that is a back surface field (BSF) layer is disposed in each of the recessed portions 11. Further, the solar cell element 10 includes an antireflection layer 5 and a front electrode 6 that are located on the first main surface 1a side of the silicon substrate 1, and includes a back electrode 7 and a passivation layer 9 that are located on the second main surface 1b side.

One example of the solar cell element that includes a p-type silicon substrate as the silicon substrate 1 (or the first semiconductor layer 2) will be described below. A polycrystalline or monocrystalline substrate may be used as the silicon substrate 1. For example, a substrate having a thickness of less than or equal to 250 µm, or a thin substrate having a thickness of less than or equal to 150 µm may be used as the silicon substrate 1. The silicon substrate 1 may have any shapes. The first semiconductor layer 2 can have the p-type by impurities, such as boron and gallium, contained as dopant elements in the silicon substrate 1.

The second semiconductor layer 3 is laminated on, for example, the first main surface 1a side of the first semiconductor layer 2. The second semiconductor layer 3 has a conductivity type (n-type in the present embodiment) reverse to the conductivity type of the first semiconductor layer 2. A p-n junction is formed between the first semiconductor layer 2 and the second semiconductor layer 3. The second semiconductor layer 3 can be formed by impurities, such as phosphorus, contained as dopant elements on the first main surface 1a side of the silicon substrate 1.

As illustrated in Fig. 3, the first main surface 1a of the silicon substrate 1 may have a finely uneven structure (texture) for reducing reflectivity of emitted light. The protruding portion of the texture has a height of about 0.1 to 10 µm, and an interval between top portions of the protruding portions adjacent to each other is about 0.1 to 20 µm. The height of the protruding portion refers to a distance from a reference line, which is a straight line through the bottom surfaces of the depressed portions in, for example, Fig. 3, to the top of the protruding portion in a direction perpendicular to the reference line. The depressed portion of the texture may have a substantially spherical shape, and the protruding portion may have a pyramidal shape.

The antireflection layer 5 reduces the reflectivity of light emitted to the first main surface 10a of the solar cell element 10. For example, the antireflection layer 5 may be formed of an insulating layer such as a silicon oxide layer, an aluminum oxide layer, and a silicon nitride layer, or formed of a laminated film of those films. The antireflection layer 5 may appropriately have the refractivity and thickness capable of achieving conditions of low reflection for light of sunlight in a range of wavelengths that may be absorbed by the silicon substrate 1 to contribute to electric power generation. For example, the antireflection layer 5 can have the refractivity of about 1.8 to 2.5 and the thickness of about 20 to 120 nm.

The third semiconductor layer 4 is disposed on the second main surface 1b side of the silicon substrate 1 and has the same conductivity type (p-type in the present embodiment) as the conductivity type of the first semiconductor layer 2. The third semiconductor layer 4 contains the dopant at a concentration higher than a concentration of the dopant contained in the first semiconductor layer 2. The third semiconductor layer 4 has the dopant elements at a concentration higher than a concentration of the dopant elements of the first semiconductor layer 2. The third semiconductor layer 4 forms an internal field on the second main surface 1b side of the silicon substrate 1. Thus, a decrease in efficiency of photoelectric conversion due to recombination of minority carriers is less likely to occur in the third semiconductor layer 4 near the surface of the second main surface 1b of the silicon substrate 1. The third semiconductor layer 4 can be formed by, for example, diffusing the dopant elements such as boron and aluminum to the second main surface 1b side of the silicon substrate 1. The first semiconductor layer 2 and the third semiconductor layer 4 can contain the dopant elements at the concentration of 5 × 10¹⁵ to 1 × 10¹⁷ atoms/cm³ and the concentration of 1 × 10¹⁸ to 5 × 10²¹ atoms/cm³, respectively.

The front electrode 6 is located on the first main surface 1a side of the silicon substrate 1. As illustrated in Fig. 1, the front electrode 6 includes several (for example, three in Fig. 1) first front electrodes 6a that have a linear shape and extend in a direction of an Y-axis and a plurality of second front electrodes 6b that have a linear shape and extend in a direction orthogonal to the first front electrodes 6a (in a direction of an X-axis). The first front electrode 6a on the first main surface 1a of the silicon substrate 1 is used to take the electricity obtained from the photoelectric conversion out of the solar cell element 10. The first front electrode 6a has a width of about 1 to 3 mm, for example. At least part of the first front electrode 6a is electrically connected to the second front electrode 6b. The second front electrode 6b over the first main surface 1a of the silicon substrate 1 is used to collect the electricity from the silicon substrate 1. The second front electrode 6b has a width of about 50 to 200 µm, for example. The second front electrodes 6b adjacent to each other are located at an interval of about 1 to 3 mm. In this manner, the second front electrode 6b has the width smaller than the width of the first front electrode 6a. The front electrode 6 has a thickness of about 10 to 40 µm. The front electrode 6 can be formed by, for example, firing a first silver paste that contains silver as a main component and has been applied into a desired shape by screen printing. In the present embodiment, the main component refers to the component that accounts for greater than or equal to 50% of the entire components, and the same applies to the description below. A third front electrode 6c having the linear shape and the same width as the width of the second front electrode 6b may be disposed in the peripheral portion of the silicon substrate 1 to electrically connect the second front electrodes 6b to each other.

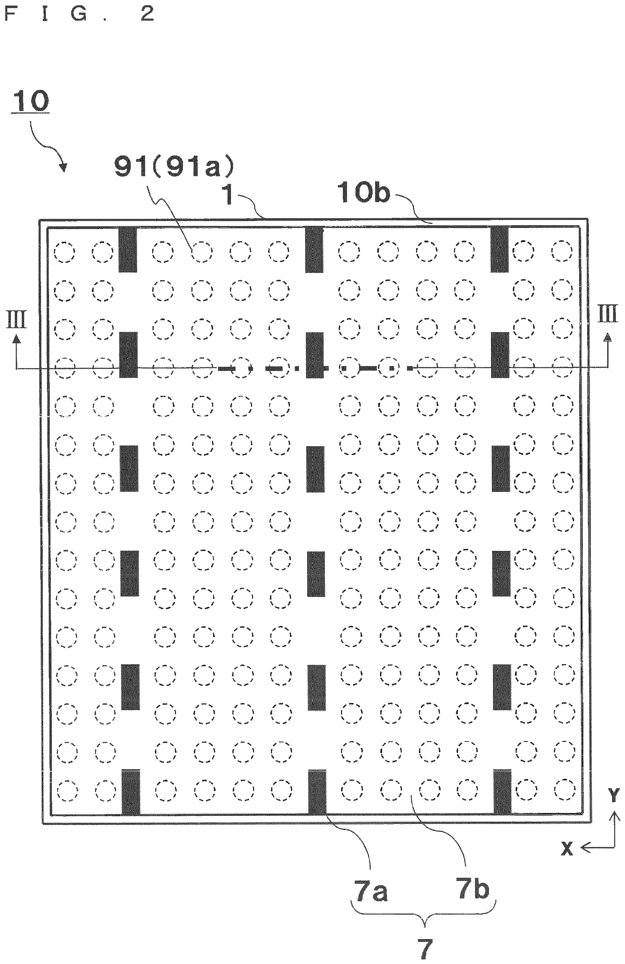

The back electrode 7 is disposed on the second main surface 1b side of the silicon substrate 1. As illustrated in Fig. 2, the back electrode 7 includes a plurality of first back electrodes 7a that are discontinuously linearly disposed in the direction of the Y-axis and a second back electrode 7b disposed substantially on the entire surface of the second main surface 1b side of the silicon substrate 1.

The first back electrode 7a over the second main surface 1b of the silicon substrate 1 is used to take the electricity obtained from the photoelectric conversion out of the solar cell element 10. The first back electrode 7a has a thickness of about 10 to 30 µm and a width of about 1 to 7 mm. The first back electrode 7a contains silver as the main component. The first back electrode 7a can be formed by, for example, firing a second silver paste that contains silver as the main component and has been applied into a desired shape by screen printing.

The second back electrode 7b over the second main surface 1b of the silicon substrate 1 is used to collect the electricity obtained from the photoelectric conversion from the silicon substrate 1, and is disposed so as to be electrically connected to the first back electrodes 7a. It suffices that at least part of the first back electrode 7a is electrically connected to the second back electrode 7b. The second back electrode 7b has a thickness of about 15 to 50 µm. For example, the second back electrode 7b is formed substantially on the entire surface of the second main surface 1b of the silicon substrate 1 except for parts of regions where the first back electrodes 7a are formed. The second back electrode 7b is electrically connected to the silicon substrate 1 through a below-mentioned first conductive portion 13 located in each hole 91 that penetrates part of the below-mentioned passivation layer 9. The second back electrode 7b may comprise a plurality of second back electrodes 7b having the linear shape, for example. In this case, the plurality of second back electrodes 7b, for example, have a width of about 100 to 500 µm and are disposed at an interval of about 1 to 3 mm in the short-side direction.

The second back electrode 7b contains aluminum as the main component. The second back electrode 7b can be formed by, for example, firing, according to a predetermined temperature profile, an aluminum paste that contains aluminum as the main component and has been applied into a desired shape with a desired thickness.

The passivation layer 9 is disposed on the second main surface 1b of the silicon substrate 1. The passivation layer 9 reduces a defect level that causes recombination of the minority carriers at an interface between the silicon substrate 1 and the passivation layer 9. For example, the passivation layer 9 is formed of an insulating layer such as a silicon oxide layer, an aluminum oxide layer, and a silicon nitride layer, or formed of a laminated film of those films. The passivation layer 9 has a thickness of about 10 to 200 nm.

If the first semiconductor layer 2 is a p-type layer, materials having a fixed negative charge, such as aluminum oxide formed by atomic layer deposition (ALD), are suitable for the passivation layer 9. In this case, an electric field effect causes electrons, which are the minority carriers, to move away from the interface between the silicon substrate 1 and the passivation layer 9, to thereby reduce recombination of the minority carriers at the interface. For the same reason, if the first semiconductor layer 2 is an n-type layer, a film having a fixed positive charge, such as silicon nitride formed by plasma enhanced chemical vapor deposition (PECVD), is preferably used.

To collect the electricity from the silicon substrate 1 by the second back electrode 7b, the second back electrode 7b and the silicon substrate 1 need to be electrically connected to each other through the holes 91 that penetrate parts of the regions of the passivation layer 9. Thus, the second back electrode 7b may be formed on the passivation layer 9 on the second main surface 1b of the silicon substrate 1 after the holes 91 that penetrate the passivation layer 9 are formed in the passivation layer 9 by, for example, irradiation with laser beams or etching. The holes 91 may have shapes of dots (broken lines) arranged discontinuously or shapes of solid lines arranged continuously. It suffices that the holes 91 (first holes 91 a) have a diameter (or a width) of about 10 to 150 µm and a pitch of about 0.05 to 2 mm.

In the present embodiment, it suffices that the passivation layer 9 is disposed at least on the second main surface 1b of the silicon substrate 1. Note that the passivation layer 9 may also be disposed on the first main surface 1a and on the side surfaces of the silicon substrate 1.

As illustrated in Figs. 4 to 7, the hole 91 is located in a position corresponding to the recessed portion 11 of the silicon substrate 1.

A void 12 and a second conductive portion 14 that contains aluminum and silicon are disposed between the recessed portion 11 of the silicon substrate 1 and the passivation layer 9 having the hole 91. The second conductive portion 14 is connected to each of the silicon substrate 1 and the first conductive portion 13. The second conductive portion 14 is preferably disposed between the wall surface of the recessed portion 11 and the passivation layer 9 to contact both of the silicon substrate 1 and the passivation layer 9.

The void 12 is located in the recessed portion 11 of the silicon substrate 1 and located in a portion where the second conductive portion 14 is not disposed. The void 12 may also be disposed on a bottom portion 11b of the recessed portion 11.

All of the recessed portion 11, the void 12, and the second conductive portion 14 may be formed simultaneously with the formation of the second back electrode 7b. Note that part of the recessed portion 11 may be separately formed by a laser. As described above, the second back electrode 7b is formed by firing, according to the predetermined temperature profile, the aluminum paste that has been applied into the desired shape with the desired thickness. The applied aluminum paste contacts the silicon substrate 1 through the holes 91 serving as contact holes formed in the passivation layer 9. The second back electrode 7b that contains aluminum is formed by firing the aluminum paste according to the predetermined temperature profile having a maximum temperature greater than or equal to the melting point of aluminum. Then, interdiffusion occurs between aluminum in the aluminum paste and the silicon substrate 1. At this time, the third semiconductor layer 4 in which aluminum is diffused at a concentration higher than the concentration in the first semiconductor layer 2 and the second conductive portion 14 that contains aluminum and silicon are formed in the silicon substrate 1. Herein, a eutectic point of the aluminum-silicon alloy is lower than the melting points of aluminum and silicon. Thus, the aluminum-silicon alloy melts once and then solidifies again during firing of the aluminum paste. In this case, an amount of diffusion of silicon into aluminum is greater than an amount of diffusion of aluminum into silicon. The recessed portion 11 is formed in the surface of the silicon substrate 1, and the void 12 is formed between the silicon substrate 1 and the passivation layer 9, depending on the difference in the amount of diffusion. The aluminum-silicon alloy then solidifies while contacting both of the silicon substrate 1 and the passivation layer 9, to thereby form the second conductive portion 14.

For example, as illustrated in Fig. 4, the second conductive portion 14 is formed on the silicon substrate 1 side of the passivation layer 9 (the upper side in Fig. 4) in a thickness direction of the silicon substrate 1 and the back electrode 7. The void 12 is formed adjacent to the second conductive portion 14. The first conductive portion 13 that contains not only aluminum but also silicon diffused from the silicon substrate 1 is formed on the second back electrode 7b in the vicinity of the hole 91.

In this manner, the second conductive portion 14 contacts both of the silicon substrate 1 and the passivation layer 9 to obtain excellent electrical contact between the silicon substrate 1 and the second back electrode 7b. Thus, the solar cell element having a high efficiency of photoelectric conversion can be provided. The reason is that the passivation layer 9 contacts the molten aluminum-silicon alloy to reduce insulation resistance of the passivation layer 9. Alternatively, the conceivable reason is that electrical continuity can be achieved between the second conductive portion 14 and the second back electrode 7b through the first conductive portion 13 disposed in the hole 91 in the passivation layer 9.

In the solar cell element 10 in the present embodiment, the region in the recessed portion 11 is not completely filled with the second conductive portion 14, and the void 12 is located in the region where the second conductive portion 14 is not located. Thus, stress concentration due to a difference in coefficient of thermal expansion between the second conductive portion 14 and the silicon substrate 1 can be reduced even in a change in temperature under hostile environments. Therefore, a crack such as a microcrack is less likely to occur in the silicon substrate 1, so that the solar cell element 10 having excellent long-term reliability can be provided.

The recessed portion 11 has an opening 11 a on the passivation layer 9 side. The size (opening area or maximum opening length in section) of the opening of the recessed portion 11 is usually greater than the size (opening area or maximum opening length in section) of the hole 91 (first hole 91 a) in the passivation layer 9, but may be smaller. For example, the opening 11 a of the recessed portion 11 has a diameter (or a width) of about 5 to 200 µm while the hole 91 (first hole 91 a) has a diameter (or a width) of about 10 to 150 µm. Note that if the size of the opening 11a is greater than the size of the hole 91, space having a sufficient volume for the void 12 and the second conductive portion 14 to coexist is formed between the recessed portion 11 and the passivation layer 9. The opening area and the maximum opening length can be measured by, for example, observing the opening 11 a of the recessed portion 11 or the hole 91 with an optical microscope or an electron microscope after removal of the back electrode 7 and the passivation layer 9, or the back electrode 7. Alternatively, the relevant portion after sampling can be measured by, after being embedded in resin and being properly cross-sectional polished, being observed with the optical microscope or the electron microscope.

If the volume of the second conductive portion 14 is smaller than the volume of the void 12 between the recessed portion 11 and the passivation layer 9, stress concentration at the boundary portion between the second conductive portion 14 and the silicon substrate 1 can be further reduced. The recessed portion 11 has a depth of about 5 to 50 µm.

The second conductive portion 14 may be continuously located from the opening 11 a of the recessed portion 11 to the lower portion of the hole 91 in the passivation layer 9. Thus, paths of the electrical contact between the second conductive portion 14 and the second back electrode 7b further increase in number, so that the reliability of the solar cell element 10 further increases.

As illustrated in Fig. 4, the second conductive portion 14 may be located not only on the silicon substrate 1 side of the passivation layer 9 but also located closer to the inside than the inner periphery of the hole 91 in the passivation layer 9. Thus, the passivation layer 9 and the second back electrode 7b can have excellent connection to the second conductive portion 14.

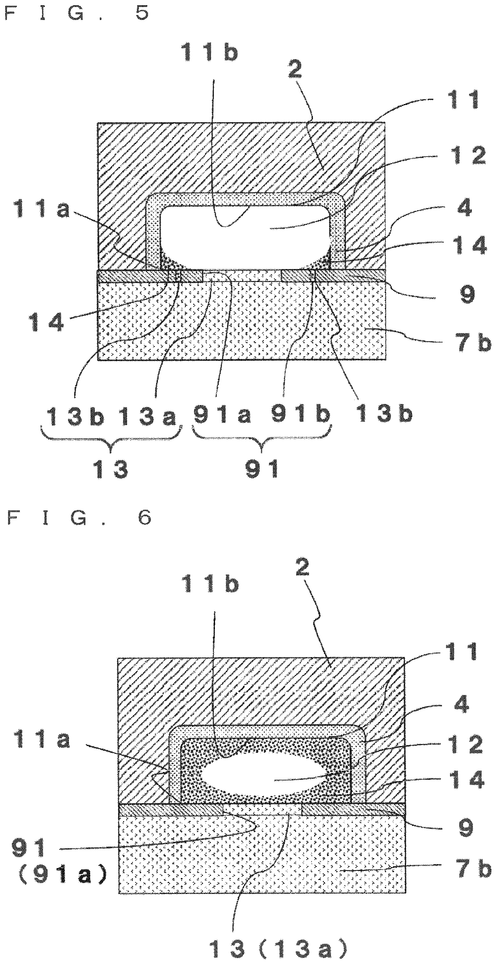

As illustrated in Fig. 5, the hole 91 may include a first hole 91a that allows electrical connection between the back electrode 7 and the silicon substrate 1 in a wide region and include a second hole 91b smaller than the first hole 91a. The second hole 91b may be formed in part of the passivation layer 9 in the process of formation of the passivation layer 9. The first conductive portion 13 may include a first primary conductive portion 13a disposed in the first hole 91a and a first secondary conductive portion 13b disposed in the second hole 91b. The second conductive portion 14 is connected to the first secondary conductive portion 13b without being directly connected to the first primary conductive portion 13a. Thus, paths of the electrical contact between the second conductive portion 14 and the second back electrode 7b further increase in number. The second conductive portion 14 is preferably connected directly to both of the first primary conductive portion 13a and the second secondary conductive portion 13b. It suffices that the first holes 91a have a diameter (or a width) of about 10 to 150 µm and a pitch of about 0.05 to 2 mm. It suffices that the second hole 91b has a diameter (or a width) of about 1 to 20 µm.

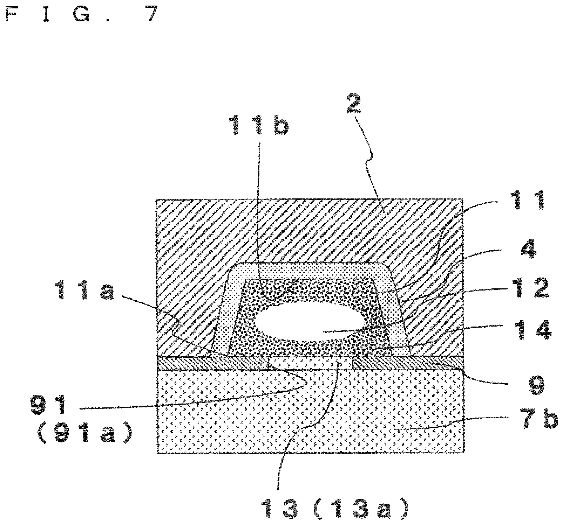

As illustrated in Figs. 6 and 7, the second conductive portion 14, the void 12, the second conductive portion 14, and the third semiconductor layer 4 may be disposed in the stated order on the second main surface 1b side of the solar cell element 10 from the hole 91 in the passivation layer 9 toward the bottom portion 11b of the recessed portion 11 in the thickness direction of the silicon substrate 1 and the back electrode 7. This results in excellent continuity of electricity from the second conductive portion 14 to the second back electrode 7b, to thereby further reduce stress concentration due to the presence of the void 12 at the boundary portion between the silicon substrate 1 (first semiconductor layer 2) and the second conductor 14.

The recessed portion 11 as illustrated in Figs. 4 to 6, for example, may have a rectangular cross-section such that the opening 11 a of the recessed portion 11 and the bottom portion 11b have almost the same length in the horizontal direction while the recessed portion as illustrated in Fig. 7 may have a trapezoidal cross-section whose length in the horizontal direction in the diagram becomes shorter from the opening 11 a toward the bottom portion 11b, or may have an arc-shaped cross-section. For the configuration illustrated in Fig. 7, an increase in contact area between the third semiconductor layer 4 and the second conductor 14 reduces contact resistance therebetween, and thus the efficiency of photoelectric conversion may improve.

### <Method for Manufacturing Solar Cell Element>

Next, each step of a method for manufacturing the solar cell element 10 will be described in detail.

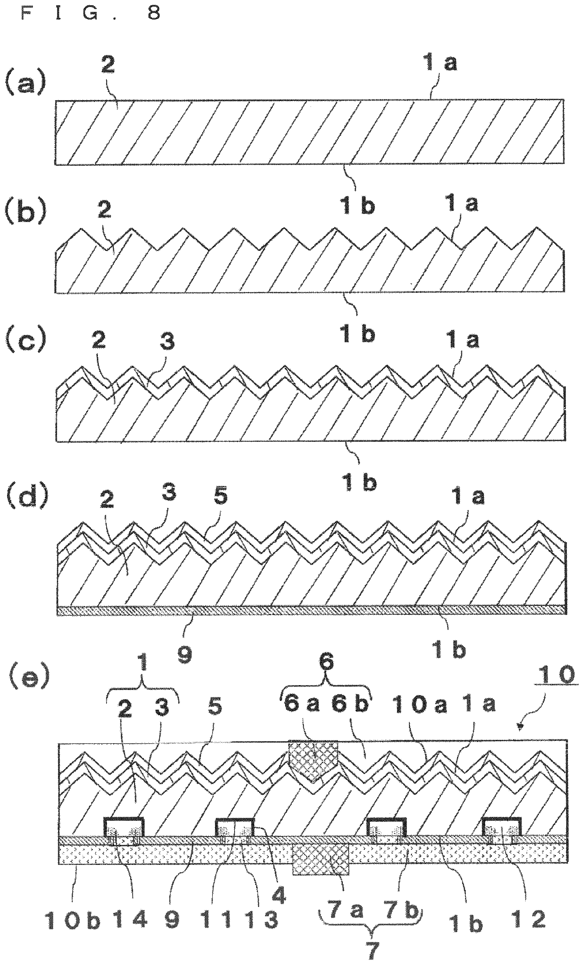

The silicon substrate 1 illustrated in Fig. 8(a) may be monocrystalline or polycrystalline. An ingot for manufacturing the silicon substrate 1 can be manufactured by, for example, Czochralski (CZ) or casting. One example of a p-type polycrystalline silicon substrate used as the silicon substrate 1 will be described below.

First, the ingot of polycrystalline silicon is manufactured by, for example, casting. It suffices that the ingot has a resistivity of about 1 to 5 Ω·cm. Boron, for example, may be added as dopant elements. The ingot is then cut into slices having a thickness of, for example, less than or equal to 250 µm with a wire saw device to manufacture the silicon substrate 1. Subsequently, a mechanically damaged layer and a polluted layer of a cut surface of the silicon substrate 1 are cleaned. For cleaning, the surface of the silicon substrate 1 may be extremely slightly etched with an aqueous solution of NaOH, KOH, hydrofluoric acid, hydrofluoric-nitric acid, or the like.

Next, as illustrated in Fig. 8(b), a texture is formed on the first main surface 1a of the silicon substrate 1. Wet etching with an alkaline solution of NaOH or the like or with an acid solution of hydrofluoric-nitric acid or the like, or dry etching with the use of reactive ion etching (RIE) may be used as the technique for forming the texture.

Next, as illustrated in Fig. 8(c), the second semiconductor layer 3 of the n-type is formed on the first main surface 1a of the silicon substrate 1 having the texture. The second semiconductor layer 3 can be formed by an application-and-thermal diffusion process in which P₂O₅ in paste form is applied to the surface of the silicon substrate 1 and thermally diffused or by a vapor thermal diffusion process in which POCl₃ (phosphorus oxychloride) in gaseous form is a source of diffusion. The second semiconductor layer 3 is formed so as to have a thickness of about 0.1 to 2 µm and a sheet resistance of about 40 to 200 Ω/□. For example, the silicon substrate 1 is heat-treated for about 5 to 30 minutes at temperatures of about 600 to 800°C in an atmosphere of diffusion gas made of POCl₃ or the like in the vapor thermal diffusion process. Consequently, phosphorus silicon glass (PSG) is formed on the surface of the silicon substrate 1. Subsequently, the silicon substrate 1 is heat-treated for about 10 to 40 minutes at high temperatures of about 800 to 900°C in an atmosphere of an inert gas such as argon and nitrogen. As a result, phosphorus is diffused from PSG into the silicon substrate 1, and the second semiconductor layer 3 is formed on the first main surface 1a side of the silicon substrate 1.

In the step of forming the second semiconductor layer 3, if the second semiconductor layer 3 is also formed on the second main surface 1b side, only the second semiconductor layer 3 formed on the second main surface 1b side is removed by etching. Consequently, the conductive region of the p-type is exposed from the second main surface 1b. For example, only the second main surface 1b side of the silicon substrate 1 is immersed in a hydrofluoric-nitric acid solution to remove the second semiconductor layer 3 formed on the second main surface 1b side. Subsequently, PSG adhering to the first main surface 1a side of the silicon substrate 1 when the second semiconductor layer 3 is formed is removed by etching. At this time, the second semiconductor layer 3 formed on the side surfaces of the silicon substrate 1 may be removed together.

In the step of forming the second semiconductor layer 3 described above, first, a diffusion mask is formed on the second main surface 1b side. The second semiconductor layer 3 is then formed by the vapor thermal diffusion process or the like. Even if the diffusion mask is subsequently removed, the second semiconductor layer 3 having the same structure as described above can be formed. In this case unlike the description above, the second semiconductor layer 3 is not formed on the second main surface 1b side, thereby eliminating the need for the step of removing the second semiconductor layer 3 on the second main surface 1b side.

As described above, the second semiconductor layer 3, which is the n-type semiconductor layer, is disposed on the first main surface 1a side. Thus, the polycrystalline silicon substrate 1 that includes the first semiconductor layer 2 having the texture on its surface can be prepared.

Next, as illustrated in Fig. 8(d), the passivation layer 9 made of aluminum oxide is formed on the second main surface 1b of the first semiconductor layer 2. The antireflection layer 5 formed of the silicon nitride film is formed on the first main surface 1a side of the silicon substrate 1.

First, ALD or PECVD, for example, is used as the technique for forming the passivation layer 9. At this time, the passivation layer 9 may be formed on the first main surface 1a of the first semiconductor layer 2 and on the entire periphery including the side surfaces of the silicon substrate 1.

In the step of forming the passivation layer 9 by ALD, first, the silicon substrate 1 on which the second semiconductor layer 3 is formed is placed in a chamber of a deposition device. While the silicon substrate 1 is heated in a temperature range of 100 to 250°C, steps of supplying an aluminum raw material, removing exhaust air of the aluminum raw material, supplying an oxidizing agent, and removing exhaust air of the oxidizing agent are each repeated for multiple times. Consequently, the passivation layer 9 made of aluminum oxide is formed on the silicon substrate 1. For example, trimethyl aluminum (TMA), triethyl aluminum (TEA), or the like may be used as the aluminum raw material in ALD. For example, water, ozone gas, or the like may be used as the oxidizing agent.

A silicon nitride film or a silicon oxide film may be further formed on aluminum oxide formed on the second main surface 1b by a technique such as PECVD. This can thus form the passivation layer 9 having the function of interface passivation achieved by aluminum oxide and the function as a protective film achieved by silicon nitride and silicon oxide.

The passivation film 9 has holes 91 that allow electrical connection between the back electrode 7 and the silicon substrate 1. The holes 91 can be formed by, for example, irradiation with laser beams or etching with a patterned etching mask.

Next, the antireflection layer 5 formed of the silicon nitride film is formed on the second semiconductor layer 3 on the first main surface 1a side of the silicon substrate 1. The antireflection film 5 is formed by, for example, PECVD or sputtering. For PECVD, the silicon substrate 1 is heated in advance at a temperature higher than a temperature during deposition. Subsequently, the heated silicon substrate 1 is supplied with a mixed gas of silane (SiH₄) and ammonia (NH₃), which is diluted with nitrogen (N₂). The mixed gas breaks down into plasma by glow discharge, reacts at a reaction pressure of 50 to 200 Pa, and is deposited, so that the antireflection layer 5 can be formed. The deposition temperature at this time is assumed to be about 350 to 650°C. A frequency of a high-frequency power supply needed for the glow discharge is 10 to 500 kHz.

A flow of gas is appropriately determined depending on the size of a reaction chamber. For example, the flow of gas is preferably within a range of 150 to 6000 sccm, and it suffices that a flow ratio B/A between a flow A of silane and a flow B of ammonia is 0.5 to 15.

Next, as illustrated in Fig. 8(e), the front electrode 6 (the first front electrode 6a and the second front electrode 6b) and the back electrode 7 (the first back electrode 7a and the second back electrode 7b) are formed as follows.

The front electrode 6 is formed by using the metal paste (first silver paste) that contains, for example, metal powder containing silver as the main component, an organic vehicle, and glass frits. First, the first silver paste is applied to the first main surface 1a of the silicon substrate 1. Subsequently, the first silver paste is fired for about a few tens of seconds to a few tens of minutes at a maximum temperature in a range of 600 to 850°C, to thereby form the front electrode 6. Screen printing or the like can be used as the application technique. After the application, the solvent may transpire at a predetermined temperature to dry. The front electrode 6 includes the first front electrode 6a and the second front electrode 6b that can be formed in a one step by using screen printing.

The first back electrode 7a is formed by using the metal paste (second silver paste) that contains, for example, metal powder containing silver as the main component, an organic vehicle, and glass frits. For example, screen printing or the like can be used as the technique for applying the second silver paste. After the application, the solvent may transpire at a predetermined temperature to dry. The silicon substrate 1 to which the second silver paste is applied is fired for about a few tens of seconds to a few tens of minutes on condition that a maximum temperature is in a range of 600 to 850°C in a firing furnace. Consequently, the first back electrode 7a is formed on the second main surface 1b side of the silicon substrate 1.

The second back electrode 7b is formed by using the metal paste (aluminum paste) that contains metal powder containing aluminum as the main component, an organic vehicle, and glass frits. The aluminum paste is applied to the second main surface 1b so as to contact a part of the second silver paste that has been previously applied. At this time, the aluminum paste may be applied to almost the entire surface of the portion of the second main surface 1b where the first back electrode 7a is not formed. Screen printing or the like can be used as the application technique. After the application, the solvent may transpire at a predetermined temperature to dry. The silicon substrate 1 to which the aluminum paste is applied is fired for about a few tens of seconds to a few tens of minutes on condition that a maximum temperature is in a range of 600 to 850°C in a firing furnace, to thereby form the second back electrode 7b on the second main surface 1b side of the silicon substrate 1.

The third semiconductor layer 4, the recessed portion 11, the void 12, the first conductive portion 13, and the second conductive portion 14 are formed upon the formation of the second back electrode 7b. The applied aluminum paste contacts the second main surface 1b of the silicon substrate 1 in the holes 91 serving as the contact holes formed in the passivation layer 9. The second back electrode 7b that contains aluminum is formed by firing the aluminum paste according to the predetermined temperature profile having the maximum temperature greater than or equal to the melting point of aluminum.

The shape and the size of the third semiconductor layer 4, the recessed portion 11, the void 12, and the second conductive portion 14 can be adjusted depending on the composition and the condition of printing (such as an applied thickness) of the aluminum paste. The amount of diffusion of silicon into aluminum is greater than the amount of diffusion of aluminum into silicon. Thus, the recessed portion 11 is formed in the surface of the silicon substrate 1 so as to face the hole 91 in the passivation layer 9. At this time, if the time for diffusion is short and the amount of diffusion of silicon into aluminum is considerably great, the second conductive portion 14 is not formed in the recessed portion 11, and only the void 12 surrounded by the recessed portion 11 and the passivation layer 9 is formed. The present embodiment adopts a technique for adding silicon or an aluminum-silicon alloy to the aluminum paste, a technique for reducing an applied thickness of the aluminum paste, or a technique for reducing a rate of temperature rise. Such a technique makes silicon less likely to be diffused from the silicon substrate 1 into the electrode that contains aluminum. Both of the void 12 and the second conductive portion 14 can be formed in the recessed portion 11. Further, silicon is less likely to be diffused from the silicon substrate 1 into the electrode that contains aluminum, allowing for an increase in the region of the second conductive portion 14 occupying the recessed portion 11.

The conceivable reason why the second conductive portion 14 in contact with both of the recessed portion 11 and the passivation layer 9 is formed is that the aluminum-silicon alloy, which is molten liquid during firing, easily contacts both of the recessed portion 11 and the passivation layer 9 due to the influence of the surface tension and solidifies while contacting them. As illustrated in Fig. 4, the second conductive portion 14 is thus disposed on the passivation layer 9 on the silicon substrate 1 side in the thickness direction of the silicon substrate 1 and the back electrode 7 in the present embodiment. The void 12 is located from the second conductive portion 14 toward the bottom portion 11b side of the recessed portion 11.

The second conductive portion 14 illustrated in Fig. 4 is continuously provided from the opening 11a of the recessed portion 11 to the hole 91 in the passivation layer 9. In this case, for example, the aluminum paste that contains 30 to 60 parts by mass of powder of a 80 mass% aluminum-20 mass% silicon alloy and 1 to 3 parts by mass of silicon powder is used for 100 parts by mass of aluminum powder. The aluminum paste is then printed so as to have a thickness of, for example, approximately 30 µm on average and fired on conditions that the silicon substrate 1 has a maximum temperature in a range of 730 to 800°C in the firing furnace and the aluminum paste has a region at a rate of temperature rise of 80°C/sec. Consequently, the second conductive portion 14 illustrated in Fig. 4 can be formed.

The second conductive portion 14 illustrated in Fig. 5 is provided only between the wall surface of the recessed portion 11 and the passivation layer 9. In this case, for example, the aluminum paste that contains 30 to 50 parts by mass of powder of the 80 mass% aluminum-20 mass% silicon alloy and 1 to 3 parts by mass of silicon powder is used for 100 parts by mass of aluminum powder. The aluminum paste is then printed so as to have a thickness of, for example, approximately 40 µm on average and fired on conditions that the silicon substrate 1 has a maximum temperature in a range of 800 to 840°C in the firing furnace and the aluminum paste has a region at a rate of temperature rise of 85°C/sec. Consequently, the second conductive portion 14 illustrated in Fig. 5 can be formed.

The second conductive portion 14 illustrated in Fig. 6 is provided on the entire periphery of the recessed portion 11. In this case, for example, the aluminum paste that contains 70 to 90 parts by mass of powder of the 80 mass% aluminum-20 mass% silicon alloy and 1 to 3 parts by mass of silicon powder is used for 100 parts by mass of aluminum powder. The aluminum paste is then printed so as to have a thickness of, for example, approximately 30 µm on average and fired on conditions that the silicon substrate 1 has a maximum temperature in a range of 730 to 800°C in the firing furnace and the aluminum paste has a region at a rate of temperature rise of 80°C/sec. Consequently, the second conductive portion 14 illustrated in Fig. 6 can be formed.

The solar cell element 10 can be manufactured in the steps described above.

The first back electrode 7a may be formed after the second back electrode 7b is formed. The first back electrode 7a may directly contact the silicon substrate 1 or the passivation layer 9 may be disposed between the first back electrode 7a and the silicon substrate 1.

The respective conductive paste may be fired at the same time after application of the respective conductive paste to form the front electrode 6, the first back electrode 7a, and the second back electrode 7b. This increases productivity and reduces thermal history of the silicon substrate 1, so that the output characteristics of the solar cell element 10 can improve.

### Example

An example that gives a concrete form to the above-mentioned embodiment will be described below. First, a plurality of silicon substrates 1 each including a p-type first semiconductor layer 2 were used as semiconductor substrates. The silicon substrates 1 were polycrystalline silicon substrates each having a square shape with one side of about 156 mm in plan view and each having a thickness of about 200 µm. The silicon substrates 1 were etched with a NaOH aqueous solution and then cleaned. The silicon substrates 1 were processed in such a manner below.

First, a texture was formed on first main surfaces 1a side of the silicon substrates 1 by RIE.

Next, PSG was formed on the surfaces of the silicon substrates 1 and phosphorus was diffused from PSG by a vapor thermal diffusion process in which POCl₃ (phosphorus oxychloride) in gaseous form was a source of diffusion. A second semiconductor layer 3 of an n-type was thus formed so as to have a sheet resistance of about 90 Ω/□. After the second semiconductor layer 3 formed on second main surfaces 1b side of the silicon substrates 1 was removed with a hydrofluoric-nitric acid solution, PSG was removed by etching with a hydrofluoric acid solution.

Next, aluminum oxide was formed on the second main surfaces 1b side of the silicon substrates 1 by ALD, and silicon nitride having the function as a protective film was formed on aluminum oxide by plasma CVD, to thereby form a passivation layer 9 having a laminated structure.

Herein, the silicon substrates 1 were placed in a chamber of a deposition device to maintain a temperature of the surfaces of the silicon substrates 1 at about 100 to 200°C. Then, TMA was used as an aluminum raw material, and ozone gas was used as an oxidizing agent to form aluminum oxide having a thickness of about 30 nm.

Subsequently, an antireflection layer 5 made of silicon nitride was formed on the first main surfaces 1a of the silicon substrates 1 by plasma CVD.

Next, the passivation layer 9 was irradiated with laser beams to have a plurality of holes 91.

A silver paste was applied to the pattern of the front electrode 6 illustrated in Fig. 1 on the first main surfaces 1a side, and a silver paste was applied to the pattern of the first back electrode 7a illustrated in Fig. 2 on the second main surfaces 1b side. An aluminum paste was applied to the pattern of the second back electrode 7b illustrated in Fig. 2 on the second main surfaces 1b side. The conductive pastes were fired at a maximum temperature of 750°C. Consequently, a third semiconductor layer 4, the front electrode 6, the first back electrode 7a, the second back electrode 7b, and a first conductive portion 13 were formed to manufacture a solar cell element 10.

In an example, the aluminum paste did not contain glass powder and contained 40 parts by mass of powder of the 80 mass% aluminum-20 mass% silicon alloy and 2 parts by mass of silicon powder for 100 parts by mass of aluminum powder. The aluminum paste was then printed so as to have a thickness of about 30 µm on average. The aluminum paste was fired on condition that the aluminum paste had a region at a rate of temperature rise of 80°C/sec. Consequently, the solar cell element 10 including a void 12 and a second conductive portion 14 in the recessed portion 11 as illustrated in Fig. 5 was manufactured.

On the other hand, in a comparative example, an aluminum paste contained 7 parts by mass of glass powder, 400 parts by mass of powder of a 75 mass% aluminum-25 mass% silicon alloy, and 33 parts by mass of silicon powder for 100 parts by mass of aluminum powder. The aluminum paste was then printed so as to have a thickness of about 30 µm on average. The aluminum paste was fired on condition that the aluminum paste had a region at a rate of temperature rise of 76°C/sec. Consequently, a solar cell element 10 in which the void 12 was not formed in the recessed portion 11 was manufactured.

Next, an initial maximum output (hereinafter referred to as Pm) of the solar cell element 10 in each of an example and a comparative example was measured. The measurement was executed under a condition of AM (air mass) 1.5 and 100 mW/cm² in accordance with JIS C 8913. Solar cell modules including each of the solar cell elements 10 in an example and a comparative example were manufactured for a reliability test. The solar cell modules were put in a thermo-hygrostat having a temperature of 125°C and a humidity of 95% to measure a rate of decrease of output from Pm after 150 hours and 450 hours. The measurement result of Pm of the solar cell element 10 in an example was normalized, assuming that the measurement result thereof in a comparative example was 100. Pm of the solar cell element 10 in an example was 100 on average.

The rate of decrease of output of the solar cell module in an comparative example was 3% after 150 hours and 10% after 450 hours. In contrast, the rate of decrease of output of the solar cell module in an example was 2% after 150 hours and 5% after 450 hours. The conceivable reason why the results above were obtained is that the void 12 formed in the recessed portion 11 caused stress concentration on the silicon substrate 1 due to the difference in coefficient of thermal expansion between the silicon substrate 1 and the second conductive portion 14 to decrease.

### REFERENCE SIGNS LIST

- 1:: silicon substrate
1a: first main surface
1b: second main surface
- 2:: first semiconductor layer (p-type semiconductor layer)
- 3:: second semiconductor layer (n-type semiconductor layer)
- 4:: third semiconductor layer (BSF layer)
- 5:: antireflection layer
- 6:: front electrode
6a: first front electrode
6b: second front electrode
6c: third front electrode
- 7:: back electrode
7a: first back electrode
7b: second back electrode
- 9:: passivation layer
91: hole
91a: first hole
91b: second hole
- 10:: solar cell element
10a: first main surface
10b: second main surface
- 11:: recessed portion
- 12:: void
- 13:: first conductive portion
- 14:: second conductive portion

## Claims

1. A solar cell element, comprising:
a silicon substrate having a plurality of recessed portions in one main surface;
a passivation layer that is disposed on the one main surface of the silicon substrate and has holes in positions corresponding to the recessed portions;
a first conductive portion disposed in each of the holes in the passivation layer;
an electrode that is disposed on the passivation layer, is connected to the first conductive portion, and contains aluminum;
a second conductive portion that is connected to each of the silicon substrate and the first conductive portion while being disposed in each of the recessed portions of the silicon substrate, and contains aluminum and silicon; and
a void that is located in each of the recessed portions of the silicon substrate and does not include the second conductive portion disposed therein.

2. The solar cell element according to claim 1, wherein the void is located between a bottom portion of each of the recessed portions of the silicon substrate and the second conductive portion.

3. The solar cell element according to claim 1, wherein the second conductive portion is also disposed on the bottom portion of each of the recessed portions of the silicon substrate.

4. The solar cell element according to any one of claims 1 to 3, wherein each of the recessed portions of the silicon substrate further includes a BSF layer disposed therein, the BSF layer contacting the second conductive portion.
